# EUROPEAN PATENT APPLICATION

(11) **EP 4 760 627 A1**
(43) Date of publication of application: **17.06.2026**
(21) Application number: 24882724.8
(22) Date of filing: 15.10.2024
(51) Int. Cl.: G06Q 50/40, G06Q 50/10, G01R 31/396, B60L 58/10

(54) **BATTERY DATA ANALYSIS SERVER AND OPERATING METHOD THEREOF**

(30) Priority: 23.10.2023 KR 20230142156
(71) Applicant: LG Energy Solution, Ltd., Seoul 07335 (KR)
(72) Inventor: LEE, Jun Hyok, Daejeon 34122 (KR)
(74) Representative: Goddar, Heinz J.
(86) International application number: PCT/KR2024/015620
(87) International publication number: WO 2025/089697

(57) **Abstract**

A battery data analysis server according to one embodiment disclosed herein includes a first communication unit configured to receive battery data from a plurality of vehicles, an analysis unit configured to determine target vehicles traveling on a target date among the plurality of vehicles, analyze each of the battery data corresponding to each of the target vehicles, and generate daily data based on the result of the analysis, a data lake configured to store the daily data; a message queue configured to acquire data information including the number of daily data stored in the data lake in real time, a storage unit configured to receive and store at least some of the daily data from the data lake, and a scheduler configured to check a load state according to data processing of the storage unit and store the daily data in the storage unit based on the load state.

## Description

### TECHNICAL FIELD

### CROSS-REFERENCE TO RELATED APPLICATION

This application claims priority to and the benefit of Korean Patent Application No. 10-2023-0142156 filed in the Korean Intellectual Property Office on October 23, 2023, the entire contents of which are incorporated herein by reference.

### TECHNICAL FIELD

Embodiments disclosed herein relate to a battery data analysis server and a method of operating the same.

### BACKGROUND ART

Recently, research and development on secondary batteries has been actively conducted. Here, the secondary battery is a battery capable of charging and discharging and includes all recent lithium ion batteries in addition to conventional Ni/Cd batteries and Ni/MH batteries. Among secondary batteries, lithium-ion batteries have an advantage of having a much higher energy density than conventional Ni/Cd batteries, Ni/MH batteries, etc. In addition, the lithium-ion batteries may be manufactured in a compact and lightweight form, and thus are used as a power source for a mobile device. In addition, the lithium-ion batteries are attracting attention as a next-generation energy storage medium as a range of use expands to a power source for an electric vehicle.

In addition, the secondary batteries may generally be used as a battery pack including a battery module in which a plurality of battery cells are connected in series and/or in parallel. In addition, the secondary batteries may be used as a battery rack including a plurality of battery modules and a rack frame accommodating the battery modules.

Meanwhile, to check states of secondary batteries included in electric vehicles (EVs), a server may collect and analyze battery data and provide result values to a user. When daily data is collected from a plurality of EVs, the amount of data is vast, and thus the time required for data analysis takes too long, and when the analysis results are stored at once, there is a problem that an excessive load is applied to a storage unit.

### DISCLOSURE

### TECHNICAL PROBLEM

Embodiments disclosed herein are directed to providing a battery data analysis server and a method of operating the same, which are capable of analyzing battery data of a plurality of vehicles.

Embodiments disclosed herein are also directed to providing a battery data analysis server and a method of operating the same, in which battery data is stored in consideration of the performance of a storage unit of the data to adjust a load of the storage unit.

Embodiments disclosed herein are also directed to providing a battery data analysis server and a method of operating the same, which increase the efficiency of data analysis by independently analyzing battery data of each of a plurality of vehicles.

Embodiments disclosed herein are also directed to providing a battery data analysis server and a method of operating the same, in which battery data is stored in consideration of the performance of a storage unit of the data to adjust a load of the storage unit.

The objects of the embodiments disclosed herein are not limited to the above-described objects, and other objects that are not described will be able to be clearly understood by those skilled in the art to which the present disclosure pertains from the following description.

### TECHNICAL SOLUTION

A battery data analysis server according to one embodiment disclosed herein includes a first communication unit configured to receive battery data from a plurality of vehicles, an analysis unit configured to determine target vehicles traveling on a target date among the plurality of vehicles, analyze each of the battery data corresponding to each of the target vehicles, and generate daily data based on the result of the analysis, a data lake configured to store the daily data, a message queue configured to acquire data information including the number of daily data stored in the data lake in real time, a storage unit configured to receive and store at least some of the daily data from the data lake, and a scheduler configured to check a load state according to data processing of the storage unit and store the daily data in the storage unit based on the load state.

According to one embodiment, when a load of a central processing unit (CPU) including the storage unit is less than a set value, the scheduler may store the daily data by transmitting the daily data from the data lake to the storage unit.

According to one embodiment, the scheduler may check the load state of the CPU based on an average activation session (AAS) of the CPU.

According to one embodiment, the scheduler may check data information of the message queue, and delete data information corresponding to data transmitted to the storage unit among the daily data from the data lake.

According to one embodiment, the scheduler may check the data information of the message queue at a preset cycle.

According to one embodiment, the storage unit may classify the daily data corresponding to each of the target vehicles for each target vehicle and store the classified daily data.

According to one embodiment, the data information may include position information of the daily data stored in the data lake, and the scheduler may store the daily data by transmitting the daily data from the data lake to the storage unit based on the position information.

According to one embodiment, the scheduler may transmit the daily data as much as the preset number of transmitted daily data from the data lake to the storage unit.

A battery data analyzing method according to one embodiment disclosed herein includes an operation of receiving battery data from a plurality of vehicles, an operation of determining target vehicles traveling on a target date among the plurality of vehicles, an operation of independently analyzing each of the battery data corresponding to each of the target vehicles, compressing an analyzed result, and generating daily data, an operation of acquiring data information including the number of daily data stored in a data lake in real time, and an operation of checking a load state according to data processing of a storage unit and storing the daily data in the storage unit based on the load state.

According to one embodiment, the operation of storing may include an operation of checking the load state of a storage unit by checking a load state of a central processing unit (CPU) including the storage unit.

According to one embodiment, when a load of the CPU including the storage unit is less than a set value, the operation of storing may include an operation of storing the daily data by transmitting the daily data from the data lake to the storage unit.

According to one embodiment, the operation of storing may include an operation of checking the load state of the CPU based on an average activation session (AAS) of the CPU.

According to one embodiment, the battery data analyzing method may further include an operation of checking data information of a message queue and deleting data information corresponding to data transmitted to the storage unit among the daily data from the data lake.

According to one embodiment, the data information may include position information of the daily data stored in the data lake, and the operation of storing may include an operation of storing the daily data by transmitting the daily data from the data lake to the storage unit based on the position information.

According to one embodiment, the operation of storing may include an operation of transmitting the daily data as much as the preset number of transmitted daily data from the data lake to the storage unit.

According to one embodiment, the operation of storing may include an operation of transmitting the daily data as much as the preset number of transmitted daily data from the data rake to the storage unit.

Detailed matters of other embodiments are included in a detailed description and accompanying drawings.

### ADVANTAGEOUS EFFECTS

According to the battery data analysis server and the method of operating the same according to the embodiments disclosed herein, the battery data of the plurality of vehicles can be analyzed.

According to the battery data analysis server and the method of operating the same according to the embodiments disclosed herein, the battery data can be stored in consideration of the performance of the storage unit of the data to adjust the load of the storage unit.

According to the battery data analysis server and the method of operating the same according to the embodiments disclosed herein, it is possible to increase the efficiency of data analysis by independently analyzing the battery data of each of the plurality of vehicles.

According to the battery data analysis server and the method of operating the same according to the embodiments disclosed herein, the battery data can be stored in consideration of the performance of the storage unit of the data to adjust the load of the storage unit.

The effects of the battery data analysis server and the method of operating the same according to the disclosure of the present document are not limited to the above-described effects, and other effects that are not described will be able to be clearly understood by those skilled in the art according to the disclosure of the present document.

### DESCRIPTION OF DRAWINGS

FIG. 1 is a block diagram showing a battery data analysis system according to one embodiment disclosed herein.
FIG. 2 is a view showing an operation of analyzing and storing battery data by a server according to one embodiment disclosed herein.
FIG. 3 is a view showing an operation of analyzing and storing battery data by a server according to another embodiment disclosed herein.
FIG. 4 is a flowchart showing a battery data analyzing method according to one embodiment disclosed herein.
FIG. 5 is a flowchart showing an operation of storing daily data based on data information by the server according to one embodiment disclosed herein in detail.
FIG. 6 is a flowchart showing an operation of storing daily data based on data information by a server according to another embodiment disclosed herein in detail.

In the description of the drawings, the same or similar reference numerals may be used for the same or similar components.

### MODE FOR INVENTION

Hereinafter, embodiments of the present invention will be described with reference to the accompanying drawings. However, it should be understood that this is not intended to limit the present disclosure to specific embodiments and includes various modifications, equivalents, and/or alternatives of the embodiments of the present disclosure.

It should be understood that the embodiments of this document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In the present document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. Terms such as "first," "second," "first," "second," "A," "B," "(a)," or "(b)" may simply be used to distinguish the corresponding component from another and do not limit the corresponding components in another aspect (e.g., importance or order).

In the present document, when a certain (e.g., a first) component is described as being "coupled," "connected," or "joined" to another (e.g., a second) component with or without the terms "functionally" or "communicatively" or "coupled" or "connected," this means that the certain component may be connected to another component directly (e.g., in a wired or wireless manner) or indirectly (e.g., through a third component).

A method according to various embodiments disclosed herein may be provided to be included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through application stores or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or a program) of the above-described components may include a single object or a plurality of objects, and some of the plurality of objects may be separately disposed in another component. According to the embodiments disclosed herein, one or more components or operations among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

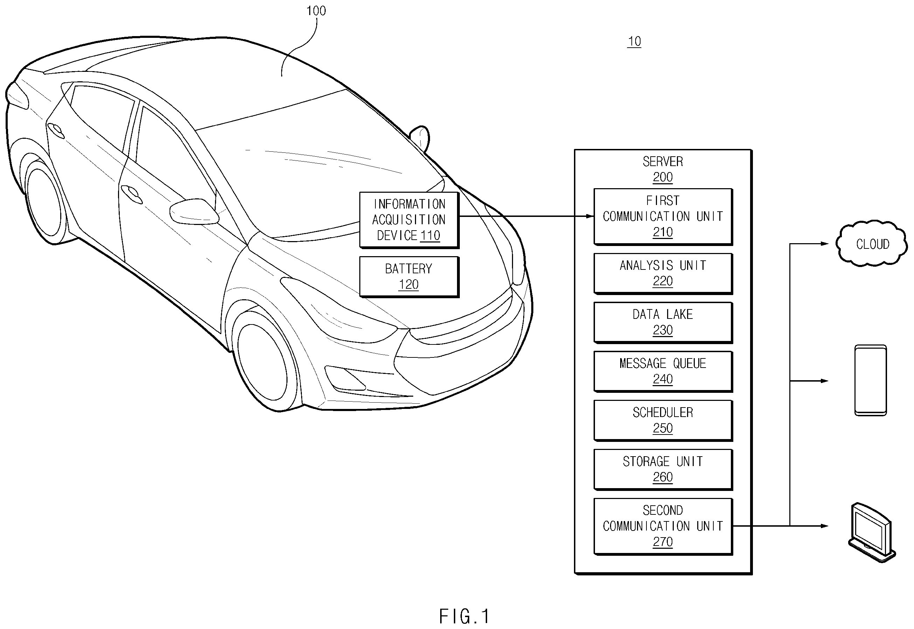

FIG. 1 is a block diagram showing a battery data analysis system according to one embodiment disclosed herein.

Referring to FIG. 1, a battery data analysis system 10 may include a target vehicle 100 and a server 200. The battery data analysis system 10 may analyze battery data of the target vehicle 100 in the server 200.

The target vehicle 100 may be an electric vehicle. The target vehicle 100 may be an electric vehicle including a battery 120. That is, the target vehicle 100 may be an electric vehicle (EV), a hybrid EV (HEV), a plug-in HEV (PHEV), or a fuel cell EV (FCEV) that includes the battery 120.

The target vehicle 100 may include an information acquisition device 110. Here, the image acquisition device 110 may include an onboard diagnostic device. That is, the information acquisition device 110 may acquire data of the target vehicle 100 and data on the battery 120 included in the target vehicle 100.

The information acquisition device 110 may generate battery data. According to an embodiment, the information acquisition device 110 may generate battery data based on a state of charge (SOC), a state of health (SOH), an open circuit voltage (OCV), charge capacity, discharge capacity, and the like of the battery 120 acquired from the battery 120.

According to an embodiment, the information acquisition device 110 may generate battery data at a predetermined cycle. The information acquisition device 110 may generate the battery data at a preset regular cycle while a target device operates or generate battery data by aggregating pieces of information about the battery 120 for one day at a daily cycle. That is, the information acquisition device 110 may generate the battery data once a day at a predetermined specific time.

The information acquisition device 110 may transmit the battery data. According to an embodiment, the information acquisition device 110 may transmit the battery data to the server 200. For example, the information acquisition device 110 may transmit the battery data to the server 200 via Long Term Evolution (LTE) communication.

The server 200 may include a first communication unit 210, an analysis unit 220, a data lake 230, a message queue 240, a scheduler 250, a storage unit 260, and a second communication unit 270. The server 200 may receive battery data from the information acquisition device 110 using each component and analyze and store the battery data.

The first communication unit 210 may receive battery data from the plurality of vehicles. According to an embodiment, the first communication unit 210 may receive the battery data from the plurality of vehicles including the target vehicle 100. For example, the first communication unit 210 may communicate with the information acquisition device 110 included in each of the plurality of vehicles to receive the battery data from each of the plurality of vehicles.

The analysis unit 220 may determine the target vehicles 100. The analyzing unit 220 may determine the target vehicles 100 traveling on a target date among the plurality of vehicles. According to an embodiment, the analysis unit 220 may determine whether each of the plurality of vehicles has traveled on the target date based on the battery data received from each of the plurality of vehicles and determine the target vehicles 100 based on the result of determination. That is, the analysis unit 220 may determine that vehicles traveling on the target date among the plurality of vehicles are the target vehicles 100, and vehicles that have not traveled on the target date may not be determined to be the target vehicles 100. According to an embodiment, the analysis unit 220 may generate an analysis target list based on the determined target vehicles 100.

The analysis unit 220 may analyze the battery data. The analyzing unit 220 may analyze the battery data of the target vehicles 100. According to an embodiment, the analysis unit 220 may analyze data of the target vehicles with reference to an analysis target list.

The analysis unit 220 may independently analyze the battery data of the target vehicles 100. The analysis unit 220 may independently analyze the battery data of each of the plurality of target vehicles 100. For example, the analysis unit 220 may simultaneously analyze the battery data corresponding to each of the target vehicles 100 in parallel. That is, the analysis unit 220 may independently analyze first battery data and second battery data rather than a method of analyzing the second battery data, which is battery data of a second target vehicle 100, after analyzing the first battery data which is battery data of a first target vehicle 100. Therefore, the analysis unit 220 may simultaneously analyze the first battery data and the second battery data, an analysis time of the first battery data may partially overlap an analysis time of the second battery data, and the analysis time of the first battery data may not overlap the analysis time of the second battery data at all. That is, the analysis unit 220 may analyze the battery data of the plurality of target vehicles 100 in a distributed parallel manner. According to an embodiment, the analysis unit 220 may distribute the battery data corresponding to the target vehicles 100 and analyze the distributed battery data based on the size of the battery data of each of the target vehicles 100.

The analysis unit 220 may generate the daily data. The analysis unit 220 may generate the daily data based on the result of analyzing the battery data of the target vehicles 100. According to an embodiment, the analysis unit 220 may generate the daily data corresponding to each of battery data of each of the target vehicles 100. That is, the analysis unit 220 may generate the daily data for each target vehicle 100.

The analysis unit 220 may compress daily data. That is, the analysis unit 220 may compress the daily data generated based on the result of analyzing the battery data. The analysis unit 220 may transmit the compressed daily data to the data lake 230.

The data lake 230 may store the battery data. The data lake 230 may store the battery data received from the plurality of vehicles by the first communication unit 210. In addition, the data lake may transmit the battery data to the analysis unit 220.

The data lake 230 may store the daily data. The data lake 230 may store the daily data generated by the analysis unit 220. According to an embodiment, the data lake 230 may classify the daily data corresponding to each of the target vehicles 100 for each target vehicle 100 and store the classified daily data. According to an embodiment, the data lake 230 may compress the daily data and store the compressed daily data.

The message queue 240 may acquire data information. The message queue 240 may acquire data information including the number of daily data stored in the data lake 230. According to an embodiment, the data information may include the number of daily data stored in the data lake 230 and storage position information of each daily data. Here, the message queue 240 is one of communication methods used to exchange data between processes or programs and may be a system for implementing message oriented middleware (MOM). In addition, the MOM may be middleware that transmits and receives data between applications using asynchronous messages.

The scheduler 250 may retrieve data information. The scheduler 250 may retrieve the data information acquired by the message queue 240. For example, the scheduler 250 may retrieve the data information of the message queue 240 to retrieve the number of daily data stored in the data lake 230 at the corresponding time point and the storage position information of each daily data. According to an embodiment, the scheduler 250 may retrieve the data information of the message queue 240 at a preset cycle.

The scheduler 250 may receive the data information. The scheduler 250 may receive the data information in response to the retrieval of the data information of the scheduler 250. Therefore, the scheduler 250 may acquire the number of daily data stored in the data lake 230 and the storage position information of each daily data.

The scheduler 250 may delete the data information. The scheduler 250 may delete the data information of the message queue 240. According to an embodiment, the scheduler 250 may request the message queue 240 to delete the data information corresponding to the daily data stored in the storage unit 260, thereby deleting the data information of the message queue 240.

The scheduler 250 may store the daily data in the storage unit 260. The scheduler 250 may transmit daily data to the storage unit 260 based on data information. That is, the scheduler 250 may control the data lake 230 to transmit the daily data to the storage unit 260 based on the data information to store the daily data in the storage unit 260. In addition, the scheduler 250 may control the data lake 230 so that the data lake 230 transmits the set number of daily data to the storage unit 260. For example, the number of daily data transmitted from the data lake 230 to the storage unit 260 may be up to 10, but is not limited thereto. According to an embodiment, the scheduler 250 may control the data lake 230 to delete the daily data transmitted from the data lake 230 to the storage unit 260.

According to an embodiment, the scheduler 250 may acquire the number of daily data being processed by the storage unit 260. That is, the scheduler 250 may acquire the number of daily data being stored by the storage unit 260. According to a load required for storage and the performance of the storage unit 260, it takes a predetermined time to store the daily data of the storage unit 260, and the scheduler 250 may acquire the number of daily data currently being stored by the storage unit 260. According to an embodiment, the scheduler 250 may acquire the number of daily data being stored by the storage unit 260 by checking information about the number of daily data being stored included in a separate sub-storage component (not shown). In this case, the sub-storage component may store the number of daily data currently being stored by the storage unit 260.

The scheduler 250 may compare the number of daily data being stored with a preset number. Here, the preset number may be set based on the performance of the storage unit 260 or a central processing unit (CPU) including the storage unit 260. When the number of daily data being stored by the storage unit 260 is less than the preset number, the scheduler 250 may control the data lake 230 to transmit the daily data to the storage unit 260. In addition, when the number of daily data being stored by the storage unit 260 is greater than or equal to the preset number, the scheduler 250 may wait for a set time without separate control. In this case, the scheduler 250 may re-check the number of daily data being stored by the storage unit 260 after waiting for the set time.

According to another embodiment, the scheduler 250 may check a load state of the storage unit 260. The scheduler 250 may check the load of the storage unit 260 according to the storage unit 260 storing the daily data. According to an embodiment, the scheduler 250 may check the load of the storage unit 260 by checking the load of the storage unit 260 or a load of the CPU including the storage unit 260. For example, the scheduler 250 may check the load of the storage unit 260 by checking an average activation session (AAS) of the CPU including the storage unit 260. Here, the AAS may be the average number of connections during a unit time.

The scheduler 250 may compare the load of the storage unit 260 with a set value. When the load of the storage unit 260 is less than the set value, the scheduler 250 may control the data lake 230 to transmit the daily data to the storage unit 260. When the load of the storage unit 260 is greater than or equal to the set value, the scheduler 250 may wait for a set time without separate control. In this case, the scheduler 250 may re-check the load of the storage unit 260 after waiting for the set time.

The storage unit 260 may store the daily data. The storage unit 260 may store the daily data received from the data lake 230. According to an embodiment, the storage unit 260 may store the daily data received from the data lake 230 under the control of the scheduler 250.

The storage unit 260 may classify the daily data and store the classified daily data. The storage unit 260 may classify the daily data corresponding to each of the target vehicles 100 for each target vehicle 100 and store the classified daily data.

The second communication unit 270 may transmit the daily data to a user. The second communication unit 270 may transmit the daily data stored in the storage unit 260 to the user. That is, the second communication unit 270 may transmit the daily data for each of the target vehicles 100 to a user corresponding to each of the target vehicles 100. For example, the second communication unit 270 may upload the daily data to a cloud and transmit the daily data to the user by allowing the user to check the daily data in the cloud. The second communication unit 270 may directly provide the daily data to a user terminal or a personal computer (PC). In addition, the second communication unit 270 may provide the daily data through a display provided in the target vehicle 100.

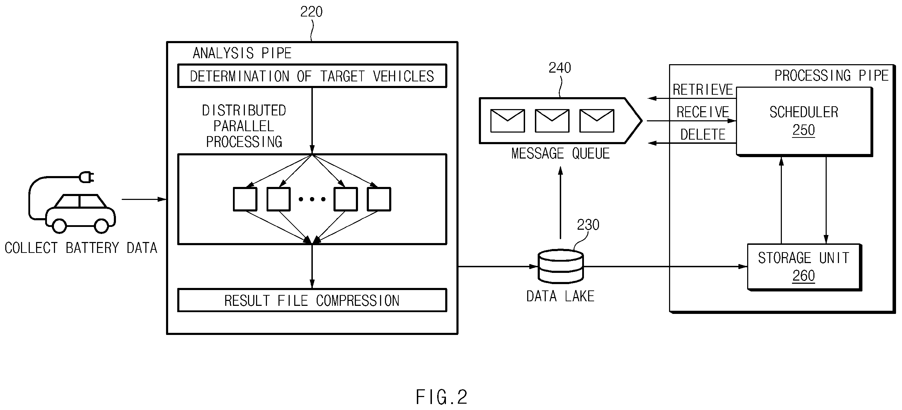

FIG. 2 is a view showing an operation of analyzing and storing battery data by a server according to one embodiment disclosed herein.

Referring to FIG. 2, the analysis unit 220 may determine the target vehicles 100. The analyzing unit 220 may determine the target vehicles 100 traveling on a target date among the plurality of vehicles. According to an embodiment, the analysis unit 220 may generate an analysis target list based on the determined target vehicles 100.

The analysis unit 220 may analyze the battery data. The analyzing unit 220 may analyze the battery data of the target vehicles 100. According to an embodiment, the analysis unit 220 may analyze data of the target vehicles with reference to an analysis target list.

The analysis unit 220 may independently analyze the battery data of the target vehicles 100. The analysis unit 220 may independently analyze the battery data of each of the plurality of target vehicles 100. For example, the analysis unit 220 may simultaneously analyze the battery data corresponding to each of the target vehicles 100 in parallel. That is, the analysis unit 220 may analyze the battery data of the plurality of target vehicles 100 in a distributed parallel manner. According to an embodiment, the analysis unit 220 may distribute the battery data corresponding to the target vehicles 100 and analyze the distributed battery data based on the size of the battery data of each of the target vehicles 100.

The analysis unit 220 may generate the daily data. The analysis unit 220 may generate the daily data based on the result of analyzing the battery data of the target vehicles 100. According to an embodiment, the analysis unit 220 may generate the daily data corresponding to each of battery data of each of the target vehicles 100. That is, the analysis unit 220 may generate the daily data for each target vehicle 100.

The analysis unit 220 may compress daily data. That is, the analysis unit 220 may compress the daily data generated based on the result of analyzing the battery data. The analysis unit 220 may transmit the compressed daily data to the data lake 230.

The data lake 230 may store the daily data. The data lake 230 may store the daily data generated by the analysis unit 220. According to an embodiment, the data lake 230 may classify the daily data corresponding to each of the target vehicles 100 for each target vehicle 100 and store the classified daily data.

The message queue 240 may acquire data information. The message queue 240 may acquire data information including the number of daily data stored in the data lake 230. According to an embodiment, the data information may include the number of daily data stored in the data lake 230 and storage position information of each daily data.

The scheduler 250 may retrieve data information. The scheduler 250 may retrieve the data information acquired by the message queue 240. For example, the scheduler 250 may retrieve the data information of the message queue 240 to retrieve the number of daily data stored in the data lake 230 at the corresponding time point and the storage position information of each daily data. According to an embodiment, the scheduler 250 may retrieve the data information of the message queue 240 at a preset cycle.

The scheduler 250 may receive the data information. The scheduler 250 may receive the data information in response to the retrieval of the data information of the scheduler 250. Therefore, the scheduler 250 may acquire the number of daily data stored in the data lake 230 and the storage position information of each daily data.

The scheduler 250 may delete the data information. The scheduler 250 may delete the data information of the message queue 240. According to an embodiment, the scheduler 250 may request the message queue 240 to delete the data information corresponding to the daily data stored in the storage unit 260, thereby deleting the data information of the message queue 240.

The scheduler 250 may store the daily data in the storage unit 260. The scheduler 250 may transmit daily data to the storage unit 260 based on data information. That is, the scheduler 250 may control the data lake 230 to transmit the daily data to the storage unit 260 based on the data information to store the daily data in the storage unit 260. In addition, the scheduler 250 may control the data lake 230 so that the data lake 230 transmits the set number of daily data to the storage unit 260. For example, the number of daily data transmitted from the data lake 230 to the storage unit 260 may be up to 10, but is not limited thereto. According to an embodiment, the scheduler 250 may control the data lake 230 to delete the daily data transmitted from the data lake 230 to the storage unit 260.

According to an embodiment, the scheduler 250 may acquire the number of daily data being processed by the storage unit 260. That is, the scheduler 250 may acquire the number of daily data being stored by the storage unit 260. According to an embodiment, the scheduler 250 may acquire the number of daily data being stored by the storage unit 260 by checking information about the number of daily data being stored included in a separate sub-storage component (not shown). In this case, the sub-storage component may store the number of daily data currently being stored by the storage unit 260.

The scheduler 250 may compare the number of daily data being stored with a preset number. Here, the preset number may be set based on the performance of the storage unit 260 or a central processing unit (CPU) including the storage unit 260. When the number of daily data being stored by the storage unit 260 is less than the preset number, the scheduler 250 may control the data lake 230 to transmit the daily data to the storage unit 260. In addition, when the number of daily data being stored by the storage unit 260 is greater than or equal to the preset number, the scheduler 250 may wait for a set time without separate control. In this case, the scheduler 250 may re-check the number of daily data being stored by the storage unit 260 after waiting for the set time.

The storage unit 260 may store the daily data. The storage unit 260 may store the daily data received from the data lake 230. According to an embodiment, the storage unit 260 may store the daily data received from the data lake 230 under the control of the scheduler 250.

The storage unit 260 may classify the daily data and store the classified daily data. The storage unit 260 may classify the daily data corresponding to each of the target vehicles 100 for each target vehicle 100 and store the classified daily data.

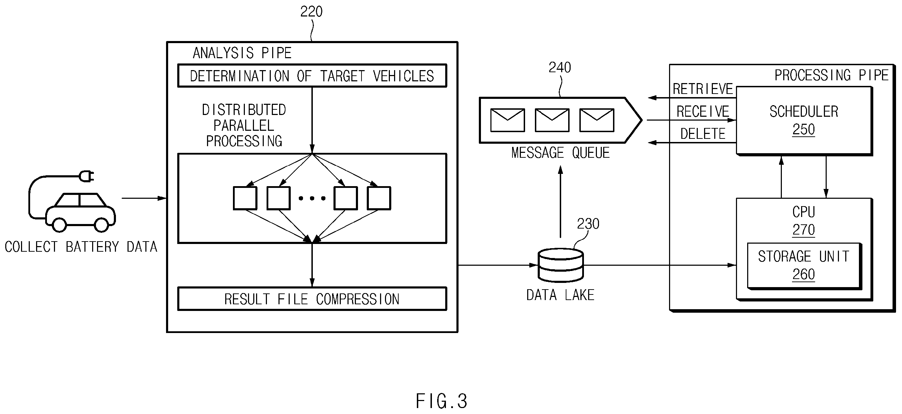

FIG. 3 is a view showing an operation of analyzing and storing battery data by a server according to another embodiment disclosed herein.

In FIG. 3, parts overlapping those of the embodiment of FIG. 2 will be omitted and differences will be mainly described.

Referring to FIG. 3, the scheduler 250 may check a load state of the storage unit 260. When data information is present in the message queue 240, the scheduler 250 may check the load state of the storage unit 260. That is, the scheduler 250 may check the load of the storage unit 260 according to the storage unit 260 storing the daily data. According to an embodiment, the scheduler 250 may check the load of the storage unit 260 by checking the load of the storage unit 260 or a load of the CPU including the storage unit 260. For example, the scheduler 250 may check the load of the storage unit 260 by checking an average activation session (AAS) of the CPU including the storage unit 260. Here, the AAS may be the average number of connections during a unit time.

The scheduler 250 may compare the load of the storage unit 260 with a set value. When the load of the storage unit 260 is less than the set value, the scheduler 250 may control the data lake 230 to transmit the daily data to the storage unit 260. When the load of the storage unit 260 is greater than or equal to the set value, the scheduler 250 may wait for a set time without separate control. In this case, the scheduler 250 may re-check the load of the storage unit 260 after waiting for the set time.

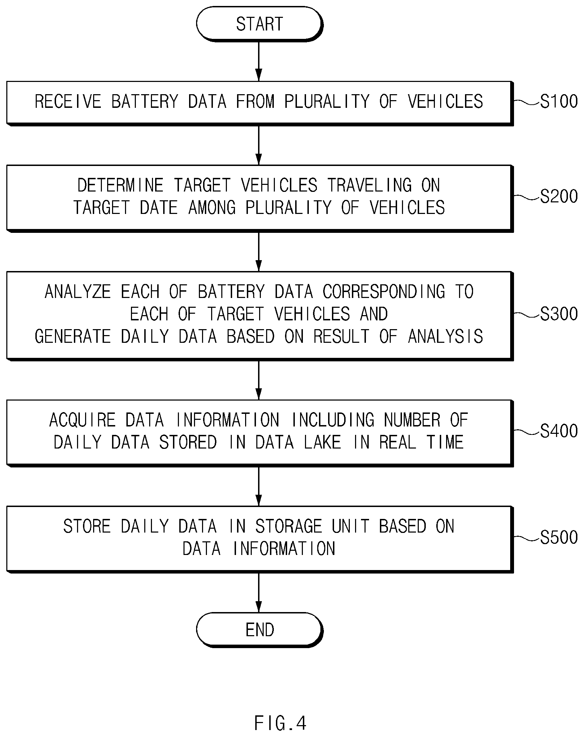

FIG. 4 is a flowchart showing a battery data analyzing method according to one embodiment disclosed herein.

The embodiment illustrated in FIG. 4 is only one embodiment, the order of operations according to various embodiments of the present invention may be different from that illustrated in FIG. 4, and some operations illustrated in FIG. 4 may be omitted, the order between the operations may be changed, or the operations may be merged.

Referring to FIG. 4, the battery data analyzing method may include an operation S100 of receiving battery data from a plurality of vehicles, an operation S200 of determining the target vehicles 100 traveling on the target date among the plurality of vehicles, an operation S300 of analyzing battery data corresponding to each of the target vehicles 100 and generating daily data based on the result of the analysis, an operation S400 of acquiring data information including the number of daily data stored in the data lake 230 in real time, and an operation S500 of storing the daily data in the storage unit 260 based on the data information.

Hereinafter, the operations S100 to S500 will be described in detail with reference to FIGS. 1 to 3.

In the operation S100 of the battery data analyzing method, the server 200 may receive the battery data from the plurality of vehicles.

In the operation S200, the server 200 may determine the target vehicles 100 traveling on the target date among the plurality of vehicles. The server 200 may determine the target vehicles 100 traveling on the target date among the plurality of vehicles. According to an embodiment, the server 200 may determine whether each of the plurality of vehicles has traveled on the target date based on the battery data received from each of the plurality of vehicles and determine the target vehicles 100 based on the result of the determination.

In the operation S300, the server 200 may analyze each of the battery data corresponding to each of the target vehicles 100 and generate the daily data based on the result of the analysis. The server 200 may independently analyze the battery data of the target vehicles 100. The server 200 may independently analyze the battery data of each of the plurality of target vehicles 100. For example, the server 200 may simultaneously analyze the battery data corresponding to each of the target vehicles 100 in parallel.

In the operation S400, the server 200 may acquire data information including the number of daily data stored in the data lake 230. According to an embodiment, the data information may include the number of daily data stored in the data lake 230 and storage position information of each daily data.

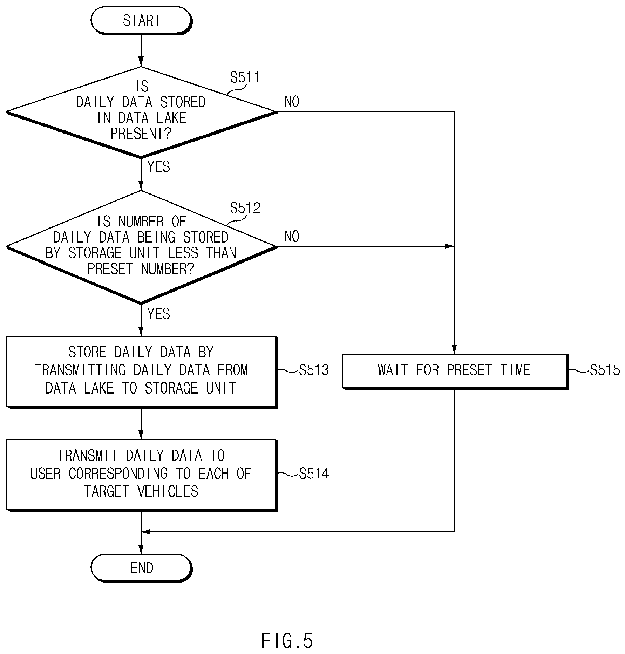

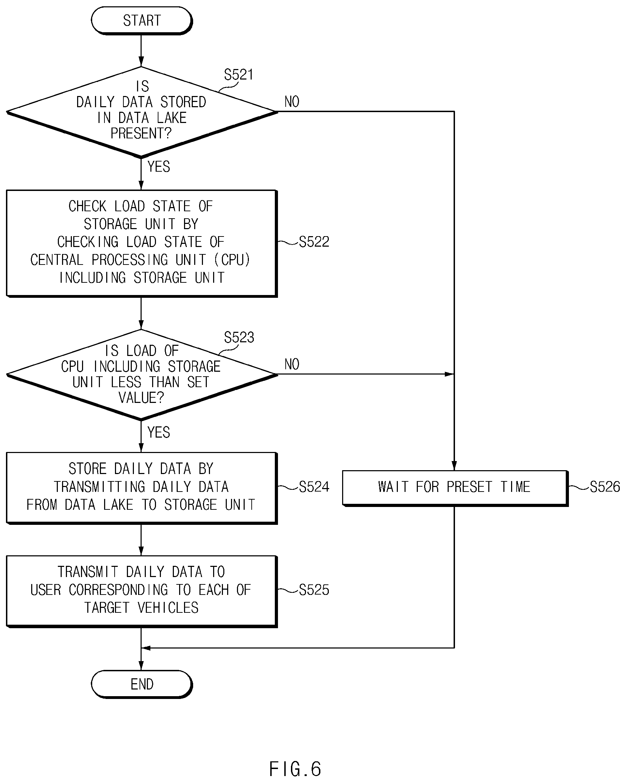

In the operation S500, the server 200 may transmit daily data to the storage unit 260 based on the data information. The server 200 may store the data information by transmitting the daily data stored in the data lake 230 to the storage unit 260 based on the data information and storing the daily data. The operation S500 will be described below in detail with reference to FIGS. 5 and 6.

FIG. 5 is a flowchart showing an operation of storing daily data based on data information by the server according to one embodiment disclosed herein in detail.

In the operation S511, the server 200 may determine whether the daily data stored in the data lake 230 is present. The server 200 may retrieve the data information. The server 200 may retrieve the data information acquired by the message queue 240. The server 200 may receive the data information. The server 200 may receive the data information in response to the retrieval of the data information by the server 200. Therefore, the server 200 may acquire the number of daily data stored in the data lake 230 and the storage position information of each daily data. The server 200 may delete the data information. The server 200 may delete the data information of the message queue 240. Therefore, the server 200 may determine whether the daily data stored in the data lake 230 is present.

When the daily data stored in the data lake 230 is present, operation S512 may be performed. When the daily data stored in the data lake 230 is not present, operation S515 may be performed.

In the operation S512, the server 200 may determine whether the number of daily data being stored by the storage unit 260 is less than a preset number. Here, the preset number may be set based on the performance of the storage unit 260 or a CPU including the storage unit 260. When the number of daily data being processed by the storage unit 260 is less than the preset number, operation S513 may be performed. When the number of daily data being processed by the storage unit 260 is greater than or equal to the preset number, the operation S515 may be performed.

In the operation S513, the server 200 may store the daily data by transmitting the daily data from the data lake 230 to the storage unit 260. In this case, the server 200 may store the daily data by transmitting the set number of daily data to the storage unit 260.

In operation S514, the server 200 may transmit the daily data to a user corresponding to each of the target vehicles 100. The second communication unit 270 may transmit the daily data stored in the storage unit 260 to the user. That is, the second communication unit 270 may transmit the daily data for each of the target vehicles 100 to a user corresponding to each of the target vehicles 100. For example, the second communication unit 270 may upload the daily data to a cloud and transmit the daily data to the user by allowing the user to check the daily data in the cloud. The second communication unit 270 may directly provide the daily data to a user terminal or a personal computer (PC). In addition, the second communication unit 270 may provide the daily data through a display provided in the target vehicle 100.

In the operation S515, the server 200 may wait for the preset time. In this case, the server 200 may re-check the number of daily data being processed by the storage unit 260 after waiting for the set time.

FIG. 6 is a flowchart showing an operation of storing daily data based on data information by a server according to another embodiment disclosed herein in detail.

In operation S521, the server 200 may determine whether the daily data stored in the data lake 230 is present. The server 200 may determine whether the daily data stored in the data lake 230 is present. The server 200 may retrieve the data information. The server 200 may retrieve the data information acquired by the message queue 240. The server 200 may receive the data information. The server 200 may receive the data information in response to the retrieval of the data information by the server 200. Therefore, the server 200 may acquire the number of daily data stored in the data lake 230 and the storage position information of each daily data. The server 200 may delete the data information. The server 200 may delete the data information of the message queue 240. Therefore, the server 200 may determine whether the daily data stored in the data lake 230 is present.

When the daily data stored in the data lake 230 is present, operation S522 may be performed. When the daily data stored in the data lake 230 is not present, operation S526 may be performed.

In the operation S522, the server 200 may check the load state of the storage unit 260 by checking the load state of the CPU including the storage unit 260. The server 200 may check the load of the storage unit 260 according to the storage unit 260 storing the daily data. According to an embodiment, the server 200 may check the load of the storage unit 260 by checking the load of the storage unit 260 or the load of the CPU including the storage unit 260. For example, the server 200 may check the load of the storage unit 260 by checking the AAS of the CPU including the storage unit 260. Here, the AAS may be the average number of connections during a unit time.

In operation S523, the server 200 may determine whether the load of the storage unit 260 or the load of the CPU including the storage unit 260 is less than the set value. When the load is less than the set value, operation S524 may be performed. When the load is greater than or equal to the set value, operation S565 may be performed.

In the operation S524, the server 200 may store the daily data by transmitting the daily data from the data lake 230 to the storage unit 260. In this case, the server 200 may store the daily data by transmitting the set number of daily data to the storage unit 260.

In operation S525, the server 200 may transmit the daily data to a user corresponding to each of the target vehicles 100. The second communication unit 270 may transmit the daily data stored in the storage unit 260 to the user. That is, the second communication unit 270 may transmit the daily data for each of the target vehicles 100 to a user corresponding to each of the target vehicles 100. For example, the second communication unit 270 may upload the daily data to a cloud and transmit the daily data to the user by allowing the user to check the daily data in the cloud. The second communication unit 270 may directly provide the daily data to a user terminal or a PC. In addition, the second communication unit 270 may provide the daily data through a display provided in the target vehicle 100.

In the operation S526, the server 200 may wait for the preset time. In this case, the server 200 may re-check the number of daily data being processed by the storage unit 260 after waiting for the set time.

The above description is merely the exemplary description of the technical spirit disclosed herein, and those skilled in the art to which embodiments disclosed herein pertain will be able to variously modify and change the embodiments without departing from the essential characteristics of the embodiments disclosed herein.

Therefore, the embodiments disclosed herein are not intended to limit the technical spirit disclosed herein, but for describing it, and the scope of the technical spirit disclosed herein is not limited by these embodiments. The scope of the technical spirit disclosed herein should be construed by the appended claims, and all technical spirits within the equivalent range should be construed as being included in the scope of this document.

### [DESCRIPTION OF DRAWING SYMBOLS]

10: battery data analysis system
100: target vehicle
110: information acquisition device
200: server
210: first communication unit
220: analysis unit
230: data lake
240: message queue
250: scheduler
260: storage unit
270: second communication unit

## Claims

1. A battery data analysis server comprising:
a first communication unit configured to receive battery data from a plurality of vehicles;
an analysis unit configured to determine target vehicles traveling on a target date among the plurality of vehicles, analyze each of the battery data corresponding to each of the target vehicles, and generate daily data based on the result of the analysis;
a data lake configured to store the daily data;
a message queue configured to acquire data information including the number of daily data stored in the data lake in real time;
a storage unit configured to receive and store at least some of the daily data from the data lake; and
a scheduler configured to check a load state according to data processing of the storage unit, and store the daily data in the storage unit based on the load state.

2. The battery data analysis server of claim 1, wherein, when a load of a central processing unit (CPU) including the storage unit is less than a set value,
the scheduler stores the daily data by transmitting the daily data from the data lake to the storage unit.

3. The battery data analysis server of claim 2, wherein the scheduler checks the load state of the CPU based on an average activation session (AAS) of the CPU.

4. The battery data analysis server of claim 1, wherein the scheduler checks data information of the message queue, and
deletes data information corresponding to data transmitted to the storage unit among the daily data from the data lake.

5. The battery data analysis server of claim 1, wherein the scheduler checks the data information of the message queue at a preset cycle.

6. The battery data analysis server of claim 1, wherein the storage unit classifies the daily data corresponding to each of the target vehicles for each target vehicle and stores the classified daily data.

7. The battery data analysis server of claim 1, wherein the data information includes position information of the daily data stored in the data lake, and
the scheduler stores the daily data by transmitting the daily data from the data lake to the storage unit based on the position information.

8. The battery data analysis server of claim 7, wherein the scheduler transmits the daily data as much as the preset number of transmitted daily data from the data lake to the storage unit.

9. A battery data analyzing method comprising:
an operation of receiving battery data from a plurality of vehicles;
an operation of determining target vehicles traveling on a target date among the plurality of vehicles;
an operation of independently analyzing each of the battery data corresponding to each of the target vehicles, compressing an analyzed result, and generating daily data;
an operation of acquiring data information including the number of daily data stored in a data lake in real time; and
an operation of checking a load state according to data processing of a storage unit and storing the daily data in the storage unit based on the load state.

10. The battery data analyzing method of claim 9, wherein the operation of storing includes an operation of checking the load state of a storage unit by checking a load state of a central processing unit (CPU) including the storage unit.

11. The battery data analyzing method of claim 10, wherein, when a load of the CPU including the storage unit is less than a set value,
the operation of storing includes an operation of storing the daily data by transmitting the daily data from the data lake to the storage unit.

12. The battery data analyzing method of claim 10, wherein the operation of storing includes an operation of checking the load state of the CPU based on an average activation session (AAS) of the CPU.

13. The battery data analyzing method of claim 9, further comprising an operation of checking data information of a message queue and deleting data information corresponding to data transmitted to the storage unit among the daily data from the data lake.

14. The battery data analyzing method of claim 9, wherein the data information includes position information of the daily data stored in the data lake, and
the operation of storing includes an operation of storing the daily data by transmitting the daily data from the data lake to the storage unit based on the position information.

15. The battery data analyzing method of claim 14, wherein the operation of storing includes an operation of transmitting the daily data as much as the preset number of transmitted daily data from the data lake to the storage unit.

16. The battery data analyzing method of claim 14, wherein the operation of storing includes an operation of transmitting the daily data as much as the preset number of transmitted daily data from the data rake to the storage unit.
